# EUROPEAN PATENT APPLICATION

(11) **EP 4 404 588 A1**
(43) Date of publication of application: **24.07.2024**
(21) Application number: 22869902.1
(22) Date of filing: 08.09.2022
(51) Int. Cl.: H04R 17/00

(54) **PIEZOELECTRIC DEVICE AND PIEZOELECTRIC MODULE**

(30) Priority: 14.09.2021 JP 2021149112
(71) Applicant: Nisshinbo Holdings Inc., Tokyo 103-8650 (JP); Nisshinbo Micro Devices Inc., Tokyo 103-8456 (JP)
(72) Inventor: MASUMOTO, Naoki, Fujimino-shi, Saitama 356-8510 (JP); KUCHIJI, Hiroyuki, Fujimino-shi, Saitama 356-8510 (JP); KIKUCHI, Toshikatsu, Fujimino-shi, Saitama 356-8510 (JP)
(74) Representative: M. Zardi & Co S.A.
(86) International application number: PCT/JP2022/033804
(87) International publication number: WO 2023/042755

(57) **Abstract**

A piezoelectric device (100) including: a substrate having a cavity (4); a piezoelectric film (3) covering the cavity (4) and laminated and supported on the substrate (1); and a first electrode (5a) and a second electrode (5b) being provided to be spaced apart from each other so as to sandwich a part of the piezoelectric film (3). The first electrode (5a) and the second electrode (5b) pass through the piezoelectric film (3) in the thickness direction of the piezoelectric film (3) and are disposed above the cavity (4), an input signal is converted to an output signal based on displacement in a direction of application of a voltage to the piezoelectric film (3) polarized in the direction of application of the voltage by applying the voltage between the first electrode (5a) and the second electrode (5b), and a miniature piezoelectric device with high sensitivity is provided that utilizes the longitudinal effect of the piezoelectric effect.

## Description

### TECHNICAL FIELD

The present invention relates to a piezoelectric device, such as an actuator, a sensor, and the like, that uses a piezoelectric material, and a piezoelectric module, and particularly relates to a piezoelectric device using a piezoelectric film laminated on a substrate, and a piezoelectric module.

### BACKGROUND ART

Conventionally, a bulk-type piezoelectric device formed by machining a piezoelectric material is being used. Moreover, with the demand for miniaturization of a piezoelectric device, a piezoelectric device having a configuration in which a lower-layer electrode, a piezoelectric film, and an upper-layer electrode are laminated on a substrate having a cavity, and an input signal is converted to an output signal based on displacement of the piezoelectric film between the lower-layer electrode and the upper-layer electrode is used. The piezoelectric device having such a structure makes it possible to transmit and receive high-frequency signals such as ultrasonic waves by reducing the thickness of the piezoelectric film disposed between the lower-layer electrode and the upper-layer electrode.

For example, for the piezoelectric device to transmit and receive the ultrasonic waves, the application range is variously expanded to include an obstacle detection device mounted to a vehicle, an ultrasonic diagnostic apparatus for medical use, and the like. In the conventionally proposed piezoelectric device, the orientation in which a voltage is applied to a piezoelectric film and the direction in which the piezoelectric film is displaced (the direction in which it extends/contracts) are different (see Patent Document 1, FIG. 4).

### PRIOR ART DOCUMENT

### Patent Document

Patent Document 1: JP 2013-135793 A

### SUMMARY OF THE INVENTION

### PROBLEM TO BE SOLVED BY THE INVENTION

As the application range of the piezoelectric device expands, there is a growing demand for higher sensitivity as well as miniaturization of the piezoelectric device. Now, in a common piezoelectric material, it is known that the transverse effect (d31 mode) of the piezoelectric effect is smaller than the longitudinal effect (d33 mode) thereof. The above-described piezoelectric device in which the miniaturization is realized is a piezoelectric device utilizing the transverse effect in which the orientation of a voltage being applied to the piezoelectric film and the orientation of displacement of the piezoelectric film are orthogonal. Thus, a problem to be solved of the present invention is to provide a miniature piezoelectric device with high sensitivity, which utilizes the longitudinal effect of the piezoelectric effect.

### MEANS TO SOLVE THE PROBLEM

One embodiment of a piezoelectric device of the present invention comprises a substrate having a cavity; a piezoelectric film covering the cavity and laminated and supported on the substrate; and a first electrode and a second electrode being provided to be spaced apart from each other so as to sandwich a part of the piezoelectric film, wherein the first electrode and the second electrode pass through the piezoelectric film in the thickness direction of the piezoelectric film and are disposed above the cavity, and wherein an input signal is converted to an output signal based on displacement in a direction of application of a voltage to the piezoelectric film polarized in the direction of application of the voltage by applying the voltage between the first electrode and the second electrode.

### EFFECTS OF THE INVENTION

According to the piezoelectric device of the present invention, since the piezoelectric device is configured to utilize the longitudinal effect of the piezoelectric effect, displacement of a piezoelectric film is large, making it possible to provide a miniature piezoelectric device with high sensitivity.

### BRIEF DESCRIPTION OF THE DRAWINGS

FIG. 1 is a schematic plan view of a piezoelectric device being one embodiment (Embodiment 1) of the present invention.
FIG. 2 is a schematic cross-sectional view of the piezoelectric device along a line A-A in FIG. 1.
FIG. 3 is a schematic cross-sectional view of a piezoelectric device being another embodiment (Embodiment 2) of the present invention.
FIG. 4 is a schematic plan view of a piezoelectric device being yet another embodiment (Embodiment 3) of the present invention.
FIG. 5 is a schematic cross-sectional view of the piezoelectric device along a line B-B in FIG. 4.
FIG. 6 is a schematic cross-sectional view of a piezoelectric device being yet a further embodiment (Embodiment 4) of the present invention.
FIG. 7 is a schematic plan view of a piezoelectric device being yet another further embodiment (Embodiment 5) of the present invention.
FIG. 8 is a schematic cross-sectional view of the piezoelectric device along a line C-C in FIG. 7.

### EMBODIMENT FOR CARRYING OUT THE INVENTION

### [Piezoelectric device]

Next, embodiments of a piezoelectric device of the present invention will be described with reference to the drawings, but the present invention is not limited to these embodiments, so that members, materials, and the like to be described below can be variously changed within the scope of the gist of the present invention. Moreover, the size, positional relationship, and the like between the respective components are for convenience, so that they do not strictly reflect the actual situation.

A piezoelectric device of the present invention is configured to displace a piezoelectric film by an input signal, utilizing the longitudinal effect (d33 mode) of the piezoelectric effect, to convert it to an output signal based on the displacement in a piezoelectric device having a cavity, which piezoelectric device realizes miniaturization. Therefore, displacement of the piezoelectric film is larger than that in the conventional piezoelectric device utilizing the transverse effect, making it possible to convert the input signal to the output signal based on a larger displacement. As a result, it is possible to provide a miniature piezoelectric device with high sensitivity.

### (Embodiment 1)

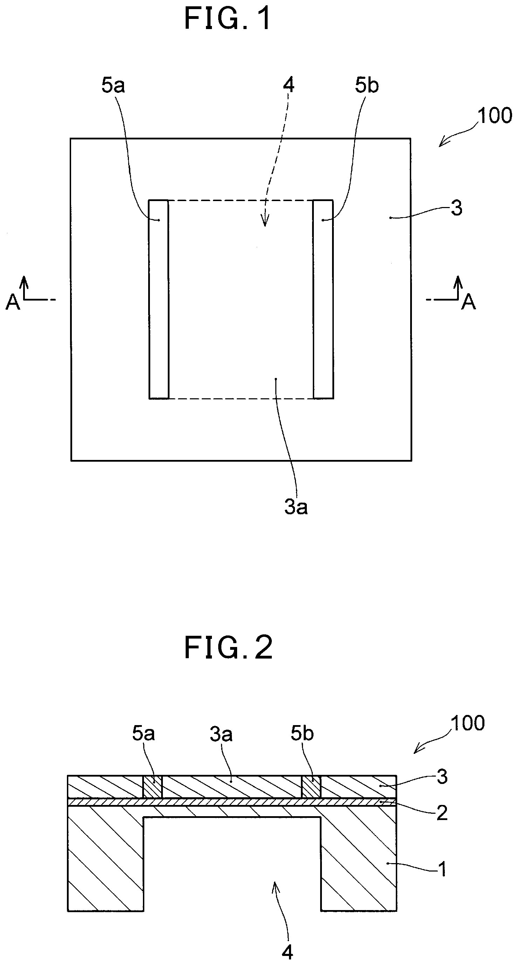

First, Embodiment 1 of the piezoelectric device of the present invention will be described. FIG. 1 shows a schematic plan view for explaining Embodiment 1 of the piezoelectric device of the present invention and FIG. 2 shows a schematic cross-sectional view of the piezoelectric device along a line A-A in FIG. 1, respectively. As shown in FIGS. 1 and 2, in a piezoelectric device 100 of the present embodiment, a piezoelectric film 3 is formed in a laminated manner on a substrate 1 via an insulating film 2. A part of the substrate 1 is removed and a cavity 4 having a quadrilateral shape in planar view is formed therein. The piezoelectric film 3 has the shape of a flat plate with a thickness at which it can vibrate at a predetermined frequency and has a front surface (a surface opposite to the substrate) and a back surface (a surface on the side of the substrate). The back surface of the piezoelectric film 3 is connected to the substrate 1 via the insulating film 2, and supported by a thick portion of the substrate 1, in which the cavity 4 is not formed. Reference numeral 3a denotes a part, which is sandwiched between electrodes 5a and 5b and is displaced, of the piezoelectric film 3. In the example shown in FIG. 2, the piezoelectric device is configured to have a shape in which a part of the substrate 1 is left in a region in which the cavity 4 is formed. This is because, as it is necessary to reduce the thickness of the piezoelectric film 3a in a case of realizing transmission/reception in the ultrasonic band, the part of the substrate 1 is left such that the thickness thereof is kept to a degree not to hinder displacement while preventing the breakage and the like of the piezoelectric film 3a. Similarly, the thickness of the insulating film 2 is also kept to a degree not to hinder displacement.

In the piezoelectric film 3, one pair of electrodes 5a and 5b (one corresponding to a first electrode and the other corresponding to a second electrode) is provided. The pair of electrodes 5a and 5b passes through the piezoelectric film 3 from the front surface to the back surface (in the thickness direction) of the piezoelectric film 3 and the electrodes are opposed substantially parallel and spaced apart from each other so as to sandwich a part of the piezoelectric film 3 in the extending direction of the piezoelectric film 3. The electrodes 5a and 5b of the pair of electrodes are respectively disposed above the cavity 4 and at opposing parts of the peripheral portion of the cavity 4 (a region in the vicinity of a cavity-side-edge of a joint portion between the piezoelectric film 3 and a part of the substrate 1 in which the cavity 4 is not formed).

By disposing in this manner, when a voltage is applied between the electrodes 5a and 5b with a voltage-applying unit not shown, the piezoelectric film 3a between the above-mentioned electrodes 5a and 5b polarizes in the direction of application of the voltage (the direction parallel to the surface of the piezoelectric film 3).

In a case that the piezoelectric device 100 of the present embodiment is used as a transmitting apparatus, by applying a voltage (corresponding to an input signal) at a predetermined frequency between the electrodes 5a and 5b, the piezoelectric film 3a is displaced so as to extend in a direction parallel to the polarization direction. By the above-mentioned displacement, the piezoelectric film 3a vibrates and an output signal (a transmission signal such as an ultrasonic signal, for example) is emitted from the piezoelectric film 3a.

Moreover, in a case that the piezoelectric device 100 of the present embodiment is used as a receiving apparatus, by the piezoelectric film 3a vibrating (an input signal) in a state in which a predetermined voltage is applied between the electrodes 5a and 5b and the piezoelectric film 3a is polarized, the piezoelectric film 3a is displaced so as to extend in a direction parallel to the polarization direction. The voltage variation associated with this displacement can be obtained as an output signal (a receiving signal) between the electrodes 5a and 5b.

By setting appropriately the thickness and the size of the piezoelectric film 3, and the interval between the pair of electrodes 5a and 5b, and setting appropriately the direction of application of the voltage to be applied between the pair of electrodes 5a and 5b, it is possible to transmit/receive an input/output signal by displacement (vibration) at a desired frequency.

As described above, the piezoelectric device 100 of the present embodiment is configured to utilize displacement of the longitudinal effect of the piezoelectric effect and can obtain displacement larger than displacement utilizing the transverse effect as in the conventional piezoelectric device. In other words, the piezoelectric device 100 of the present embodiment can obtain a larger output signal for a certain displacement, making it possible to realize miniaturization and higher sensitivity of the piezoelectric device.

### (Embodiment 2)

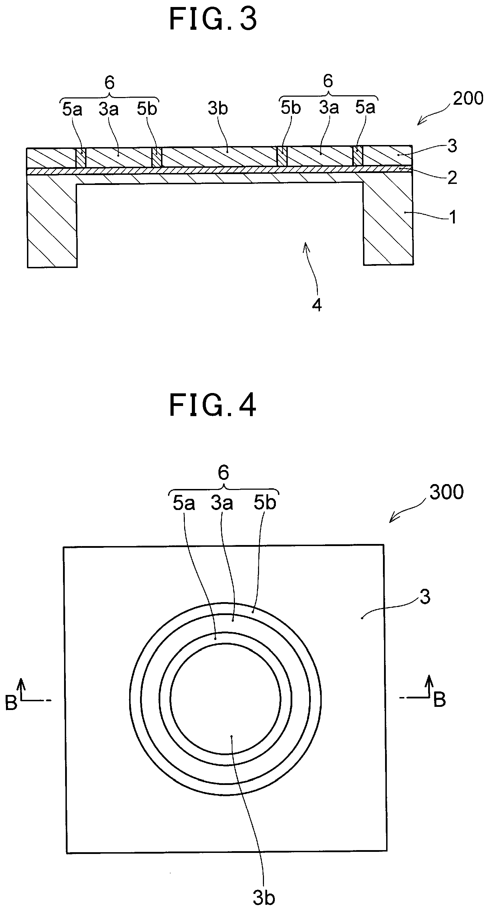

Next, Embodiment 2 of the piezoelectric device of the present invention will be described. In FIGS. 1 and 2, a piezoelectric device provided with one piezoelectric unit including the electrode 5a, the electrode 5b and a part 3a of the piezoelectric film 3 between the electrode 5a and the electrode 5b has been described, but normally a plurality of piezoelectric units being lined up is used. The present Embodiment 2 relates to a piezoelectric device including the plurality of piezoelectric units and, as an example thereof, one example of a piezoelectric device including two piezoelectric units, each of which has the configuration similar to the configuration shown in FIGS. 1 and 2, is shown in FIG. 3.

FIG. 3 is a schematic cross-sectional view of a piezoelectric device 200 in which two piezoelectric units 6 are disposed on a single cavity 4, and the two piezoelectric units 6 are disposed substantially symmetrically to the left and the right with respect to the center of the cavity 4. The configuration of the piezoelectric device 200 shown in FIG. 3 is similar to that of the piezoelectric device 100 of Embodiment 1 shown in FIGS. 1 and 2 except for the size of the cavity 4 and the configuration of the piezoelectric film 3 on the cavity 4, so that explanations thereof will be omitted.

The cavity 4 is enlarged to the left and the right than that in FIG. 1so as to dispose two piezoelectric units 6 thereon. In the piezoelectric film 3, two sets of one pair of electrodes 5a and 5b are provided left-right symmetrically and the pairs of the electrodes 5a and 5b constitute the piezoelectric units 6 along with a piezoelectric film 3a between the electrodes 5a and 5b, respectively. The pair of electrodes 5a and 5b passes through the piezoelectric film 3 from the front surface to the back surface (in the thickness direction) thereof and the electrodes are opposed substantially parallel and spaced apart from each other so as to sandwich a part of the piezoelectric film 3 in the extending direction of the piezoelectric film 3. The piezoelectric units 6 are respectively disposed at a position above opposing parts of the peripheral portion of the cavity 4 (a region in the vicinity of a cavity-side-edge of a joint portion between the piezoelectric film 3 and a part of the substrate 1 in which the cavity 4 is not formed) so as to sandwich piezoelectric film 3b between the piezoelectric units and with the respective electrodes 5a positioned on the outside.

In the respective piezoelectric units 6 being disposed in this manner, when a voltage is applied between the electrodes 5a and 5b with a voltage-applying unit not shown, the two piezoelectric films 3a between the electrodes 5a and 5b polarize in directions of application of the voltage (the directions being parallel to the surface of the piezoelectric film 3 and being mutually opposite).

In a case that the piezoelectric device 200 of the present embodiment is used as a transmitting apparatus, by applying a voltage (corresponding to an input signal) at a predetermined frequency between the electrodes 5a and 5b, the two piezoelectric films 3a are displaced so as to extend in directions being parallel to the polarization directions and being mutually opposite. In the piezoelectric device 200 of the present embodiment, by the displacement of the piezoelectric films 3a, the piezoelectric film 3b between the piezoelectric units 6 is also displaced. By the above-mentioned displacements, an output signal (an ultrasonic signal, for example) is emitted from the piezoelectric films (3a and 3b).

Moreover, in a case that the piezoelectric device 200 of the present embodiment is used as a receiving apparatus, by the piezoelectric films 3a and 3b vibrating (an input signal) in a state in which a predetermined voltage is applied between the electrodes 5a and 5b and the piezoelectric films 3a is polarized, the piezoelectric films 3a are displaced so as to extend in directions parallel to the polarization directions. The voltage variation associated with the above-mentioned displacement can be obtained as an output signal (a receiving signal) between the electrodes 5a and 5b.

By appropriately disposing a plurality of piezoelectric units 6 on a single cavity 4, displacements of the individual piezoelectric units 6 can influence each other to displace a piezoelectric film between the piezoelectric units 6. For example, to further displace a part of the piezoelectric film at the center of the cavity 4, a plurality of piezoelectric units can also be disposed so as to surround a region of the piezoelectric film 3, which region corresponds to the center of the cavity 4.

By setting appropriately the thickness of the piezoelectric film 3, the size and arrangement of the respective piezoelectric units 6, and the interval between the pair of electrodes 5a and 5b, and setting appropriately directions of application of the voltage to be applied between the pair of electrodes 5a and 5b, it is possible to transmit/receive an input/output signal by displacement (vibration) at a desired frequency.

As described above, the piezoelectric device 200 of the present embodiment is also configured to utilize displacement of the longitudinal effect of the piezoelectric effect and can obtain displacement larger than displacement utilizing the transverse effect as in the conventional piezoelectric device. In other words, the piezoelectric device 200 of the present embodiment can obtain a larger output signal for a certain displacement, making it possible to realize miniaturization and higher sensitivity of the piezoelectric device. In particular, in the present embodiment, an input signal can be converted to an output signal also by displacement of a piezoelectric film between a plurality of piezoelectric units (3b in FIG. 3, and the like), which is preferable.

### (Embodiment 3)

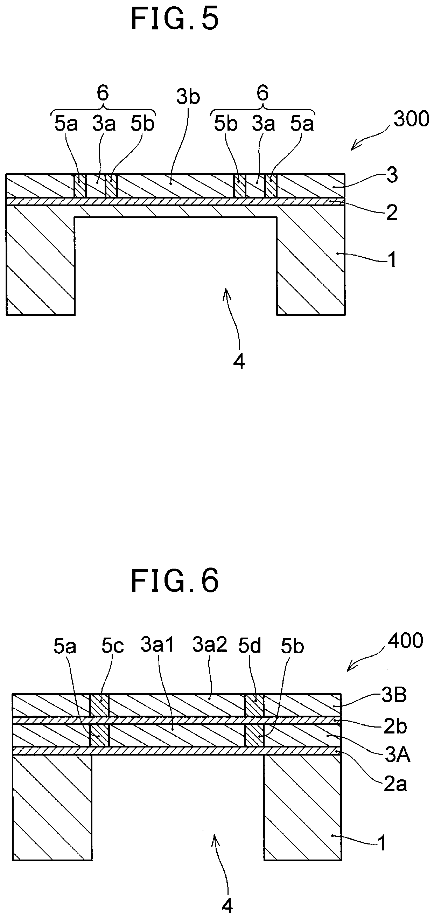

Next, Embodiment 3 of the piezoelectric device of the present invention will be described. FIG. 4 shows a schematic plan view for explaining Embodiment 3 of the piezoelectric device of the present invention and FIG. 5 shows a schematic cross-sectional view of the piezoelectric device along a line B-B in FIG. 4, respectively. As shown in FIGS. 4 and 5, in a piezoelectric device 300 of the present embodiment, a piezoelectric film 3 is formed in a laminated manner on a substrate 1 via an insulating film 2. A part of the substrate 1 is removed and a cavity 4 being circularly shaped in planar view is formed therein. The piezoelectric film 3 is configured to have the shape of a flat plate with a thickness at which it can vibrate at a predetermined frequency. The back surface of the piezoelectric film 3 is connected to the substrate 1 and supported by the substrate 1 via the insulating film 2.

In the piezoelectric film 3, one pair of electrodes 5a and 5b is disposed. The pair of electrodes 5a and 5b passes through the piezoelectric film 3 from the front surface to the back surface (in the thickness direction) thereof and the electrodes are disposed concentrically and spaced apart from each other so as to sandwich a part (piezoelectric film 3a) of the piezoelectric film 3. The electrodes 5a and 5b of the pair of electrodes are disposed at the peripheral portion (a region in the vicinity of a cavity-side-edge of a joint portion between the piezoelectric film 3 and a part of the substrate 1 in which the cavity 4 is not formed) of the piezoelectric film 3 located above the cavity 4. The piezoelectric device 300 of the present embodiment is an example of a piezoelectric device including one piezoelectric unit 6 including the electrode 5a, the electrode 5b, and the donut-shaped piezoelectric film 3a between the first electrode and the second electrode in the piezoelectric film 3.

By disposing in this manner, when a voltage is applied between the electrodes 5a and 5b with a voltage-applying unit not shown, the piezoelectric film 3a between the above-mentioned electrodes 5a and 5b polarizes in the direction of application of the voltage (the direction parallel to the surface of the piezoelectric film 3).

In a case that the piezoelectric device 300 of the present embodiment is used as a transmitting apparatus, by applying a voltage (corresponding to an input signal) at a predetermined frequency between the electrodes 5a and 5b, the piezoelectric film 3a is displaced so as to extend in a direction parallel to the polarization direction. In the present embodiment, by the displacement of the piezoelectric film 3a, a piezoelectric film 3b surrounded by the piezoelectric unit 6 constituted by the piezoelectric film 3a and the like is displaced. By the above-mentioned displacements, an output signal (an ultrasonic signal, for example) is emitted from the piezoelectric films 3a and 3b.

Moreover, in a case that the piezoelectric device 300 of the present embodiment is used as a receiving apparatus, by the piezoelectric films 3a and 3b vibrating (an input signal) in a state in which a predetermined voltage is applied between the electrodes 5a and 5b and the piezoelectric film 3a is polarized, the piezoelectric films 3a and 3b are displaced so as to extend in a direction parallel to the polarization direction. The voltage variation associated with the above-mentioned displacement can be obtained as an output signal (a receiving signal) between the electrodes 5a and 5b.

By setting appropriately the thickness and the size of the piezoelectric film 3, and the interval between the pair of electrodes 5a and 5b, and setting appropriately the direction of application of the voltage to be applied between the pair of electrodes 5a and 5b, it is possible to transmit/receive an input/output signal by displacement (vibration) at a desired frequency.

As described above, the piezoelectric device 300 of the present embodiment is also configured to utilize displacement of the longitudinal effect of the piezoelectric effect and can obtain displacement larger than displacement utilizing the transverse effect as in the conventional piezoelectric device. In other words, the piezoelectric device 300 of the present embodiment can obtain a larger output signal for a certain displacement, making it possible to realize miniaturization and higher sensitivity of the piezoelectric device. In particular, in the present embodiment, an input signal can be converted to an output signal also by displacement of the piezoelectric film 3b surrounded by the piezoelectric unit 6, which is preferable.

### (Embodiment 4)

Next, Embodiment 4 of the piezoelectric device of the present invention will be described. FIG. 6 is a schematic cross-sectional view for explaining Embodiment 4 of the piezoelectric device of the present invention. In a piezoelectric device 400 of the present embodiment, a piezoelectric film 3A is formed in a laminated manner on a substrate 1 via an insulating film 2a. Moreover, a piezoelectric film 3B is formed in a laminated manner on the piezoelectric film 3A via an insulating film 2b. A part of the substrate 1 is removed and a cavity 4 having a quadrilateral shape in planar view is formed therein. The piezoelectric films 3A and 3B have the shape of a flat plate with a thickness at which they can vibrate at a predetermined frequency. The back surface of the piezoelectric film 3A is connected to the substrate 1 via the insulating film 2a.

In the piezoelectric film 3A, one pair of electrodes 5a and 5b is provided. The pair of electrodes 5a and 5b passes through the piezoelectric film 3A from the front surface to the back surface (in the thickness direction) of the piezoelectric film 3A and the electrodes are opposed substantially parallel and spaced apart from each other so as to sandwich a part of the piezoelectric film 3A in the extending direction of the piezoelectric film 3A. Further, also in the piezoelectric film 3B, one pair of electrodes 5c and 5d is provided so as to overlap the one pair of electrodes 5a and 5b. The pair of electrodes 5c and 5d passes through the piezoelectric film 3B from the front surface to the back surface (in the thickness direction) of the piezoelectric film 3B and the electrodes are opposed substantially parallel and spaced apart from each other so as to sandwich a part of the piezoelectric film 3B in the extending direction of the piezoelectric film 3B. The electrodes 5a and 5c, and 5b and 5d are respectively disposed above the cavity 4 and at opposing parts of the peripheral portion of the cavity 4 (a region in the vicinity of a cavity-side-edge of a joint portion between the piezoelectric film 3A and a part of the substrate 1 in which the cavity 4 is not formed). The piezoelectric device 400 of the present embodiment is different from the piezoelectric device 100 of Embodiment 1 above in that it is configured to have a structure in which at least two piezoelectric films, each of which has one pair of electrodes provided to be spaced apart from each other so as to sandwich a part of the piezoelectric film, are laminated. The two-layer structure is described in FIG. 6, but it is not limited to two layers of piezoelectric films, so that piezoelectric films having a similar configuration can be laminated in three or more layers.

By disposing in this manner, when a voltage is applied between the electrodes 5a and 5b with a voltage-applying unit not shown, a piezoelectric film 3a1 between the above-mentioned electrodes 5a and 5b polarizes in the direction of application of the voltage (in the direction parallel to the surface of the piezoelectric film 3A). Moreover, when a voltage is applied between the electrodes 5c and 5d in a direction opposite to the direction of application of the voltage to the piezoelectric film 3a1, a piezoelectric film 3a2 between the electrodes 5c and 5d polarizes in the direction of application of the voltage.

In a case that the piezoelectric device 400 of the present embodiment is used as a transmitting apparatus, by applying a voltage at a predetermined frequency between the electrodes 5a and 5b, the piezoelectric film 3a1 is displaced so as to extend in a direction parallel to the polarization direction. At this time, by applying a voltage between the electrodes 5c and 5d in the opposite direction in synchronization with the above-mentioned predetermined frequency, the piezoelectric film 3a2 is displaced so as to contract in a direction parallel to the polarization direction. In other words, when a voltage (corresponding to an input signal) is applied to the electrodes 5a to 5d, when one of the piezoelectric films 3a1 and 3a2 is displaced so as to extend, the other of the piezoelectric films 3a1 and 3a2 is displaced so as to contract. By the above-mentioned displacements, an output signal (an ultrasonic signal, for example) is emitted from the piezoelectric films 3a and 3b.

Moreover, in a case that the piezoelectric device 400 of the present embodiment is used as a receiving apparatus, by the piezoelectric films 3a1 and 3a2 vibrating (an input signal) in a state in which a predetermined voltage is applied so as to polarize the piezoelectric film 3a1 between the electrodes 5a and 5b and the piezoelectric film 3a2 between the electrodes 5c and 5d in mutually opposite directions, displacement in which the piezoelectric films 3a1 and 3a2 respectively extend alternately in a direction parallel to the polarization direction occurs. The voltage variation associated with the above-mentioned displacement can be obtained as an output signal (a receiving signal) from at least either one of between the electrodes 5a and 5b and between the electrodes 5c and 5d.

By setting appropriately the thickness and the size of the piezoelectric films 3A and 3B, the interval between the pair of electrodes 5a and 5b, and the interval between the pair of electrodes 5c and 5d, and setting appropriately the direction of application of the voltage to be applied between the pair of electrodes 5a and 5b and between the pair of electrodes 5c and 5d, it is possible to transmit/receive an input/output signal by displacement (vibration) at a desired frequency.

As described above, the piezoelectric device 400 of the present embodiment is also configured to utilize displacement of the longitudinal effect of the piezoelectric effect and can obtain displacement larger than displacement utilizing the transverse effect as in the conventional piezoelectric device. In other words, the piezoelectric device 400 of the present embodiment can obtain a larger output signal for a certain displacement, making it possible to realize miniaturization and higher sensitivity of the piezoelectric device.

It should be noted that the multilayer structure of the piezoelectric films of the present embodiment can also be applied to the piezoelectric device 200 of Embodiment 2 shown in FIG. 3 and the piezoelectric device 300 of Embodiment 3 shown in FIGS. 4 and 5. Particularly, in all of these embodiments, the effect of increasing displacement of the piezoelectric film 3b between the piezoelectric units 6 is expected.

### (Embodiment 5)

Next, Embodiment 5 of the piezoelectric device of the present invention will be described. A case in which whole end portion of the piezoelectric film 3 is connected to the substrate 1 has been described in Embodiments 1 to 4 above, but a cantilever-type piezoelectric device in which one end of the piezoelectric film 3 is a free end will be described in the present embodiment.

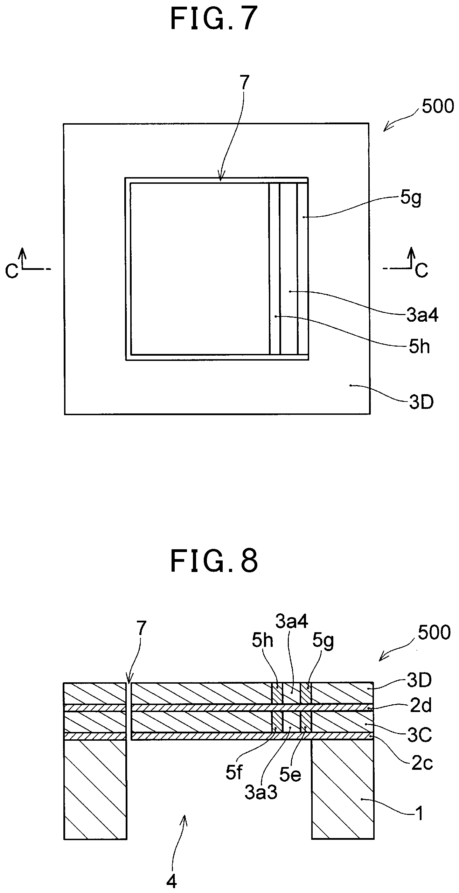

FIG. 7 shows a schematic plan view for explaining Embodiment 5 of a piezoelectric device of the present invention and FIG. 8 shows a schematic cross-sectional view of the piezoelectric device along a line C-C in FIG. 7. As shown in FIGS. 7 and 8, in a piezoelectric device 500 of the present embodiment, a piezoelectric film 3C is formed in a laminated manner on a substrate 1 via an insulating film 2c. Moreover, a piezoelectric film 3D is formed in a laminated manner on the piezoelectric film 3C via an insulating film 2d. A part of the substrate 1 is removed and a cavity 4 having a quadrilateral shape in planar view is formed therein. Furthermore, in the piezoelectric films 3C and 3D, a region located on the cavity 4 is partitioned by providing a slit 7 on three sides of the region, and the piezoelectric films 3C and 3D have the shape of a flat plate with a thickness at which they can vibrate at a predetermined frequency. A part of the piezoelectric films 3C and 3D, which is partitioned by the slit 7, is connected to and supported on the substrate 1 via the insulating film 2c with one side in which the slit 7 is not provided.

In the piezoelectric film 3C, one pair of electrodes 5e and 5f is provided. The pair of electrodes 5e and 5f passes through the piezoelectric film 3C from the front surface to the back surface (in the thickness direction) of the piezoelectric film 3C and the electrodes are opposed substantially parallel and spaced apart from each other so as to sandwich a part of the piezoelectric film 3C in the extending direction of the piezoelectric film 3C. Further, also in the piezoelectric film 3D, one pair of electrodes 5g and 5h is provided so as to overlap the one pair of electrodes 5e and 5f. The pair of electrodes 5g and 5h passes through the piezoelectric film 3D from the front surface to the back surface (in the thickness direction) thereof and the electrodes are opposed substantially parallel and spaced apart from each other so as to sandwich a part of the piezoelectric film 3D in the extending direction of the piezoelectric film 3D. The electrodes 5e-5h are respectively disposed above the cavity 4 and at opposing parts of the peripheral portion of the cavity 4 (a region in the vicinity of a cavity-side-edge of a joint portion between the piezoelectric film 3C and a part of the substrate 1 in which the cavity 4 is not formed).

By disposing in this manner, when a voltage is applied between the electrodes 5e and 5f with a voltage-applying unit not shown, a piezoelectric film 3a3 between the above-mentioned electrodes 5e and 5f polarizes in the direction of application of the voltage (the direction parallel to the surface of the piezoelectric film 3C). Moreover, when a voltage is applied between the electrodes 5g and 5h in a direction opposite to the direction of application of the voltage to the piezoelectric film 3a3, a piezoelectric film 3a4 between the electrodes 5g and 5h polarizes in the direction of application of the voltage.

In a case that the piezoelectric device 500 of the present embodiment is used as a transmitting apparatus, by applying a voltage at a predetermined frequency between the electrodes 5e and 5f, the piezoelectric film 3a3 is displaced so as to extend in a direction parallel to the polarization direction. At this time, by applying a voltage between the electrodes 5g and 5h in the opposite direction in synchronization with the above-mentioned predetermined frequency, the piezoelectric film 3a4 is displaced so as to contract in a direction parallel to the polarization direction. In other words, when a voltage (corresponding to an input signal) is applied to the electrodes 5e to 5h, when one of the piezoelectric films 3a3 and 3a4 is displaced so as to extend, the other of the piezoelectric films 3a3 and 3a4 is displaced so as to contract. By the above-mentioned displacements, the free end of the piezoelectric films 3C and 3D has a relatively large displacement, and an output signal (an ultrasonic signal, for example) is emitted from the piezoelectric films 3C and 3D.

Moreover, in a case that the piezoelectric device 500 of the present embodiment is used as a receiving apparatus, by the free end of the piezoelectric films 3C and 3D vibrating (an input signal) in a state in which a predetermined voltage is applied so as to polarize the piezoelectric film 3a3 between the electrodes 5e and 5f and the piezoelectric film 3a4 between the electrodes 5g and 5h in mutually opposite directions, displacement in which the piezoelectric films 3a3 and 3a4 respectively extend alternately in a direction parallel to the polarization direction occurs. The voltage variation associated with this displacement can be obtained as an output signal (a receiving signal) from at least either one of between the electrodes 5e and 5f and between the electrodes 5g and 5h.

By setting appropriately the thickness and the size of the piezoelectric films 3C and 3D, and the interval between the pair of electrodes 5e and 5f and the interval between the pair of electrodes 5g and 5h, and setting appropriately a method of applying a voltage to be applied between the pair of electrodes 5e and 5f and between the pair of electrodes 5c and 5d, it is possible to transmit/receive displacement (vibration) at a desired frequency.

In the present embodiment, the piezoelectric film has been explained as a multilayer structure, but the explanations can be applied for a single layer structure having only the piezoelectric film 3C, without the insulating film 2d and the piezoelectric film 3D, for example.

As described above, the piezoelectric device 500 of the present embodiment is also configured to utilize displacement of the longitudinal effect of the piezoelectric effect and can obtain displacement larger than displacement utilizing the transverse effect as in the conventional piezoelectric device. In other words, the piezoelectric device 500 of the present embodiment can obtain a larger output signal for a certain displacement, making it possible to realize miniaturization and higher sensitivity of the piezoelectric device. Particularly in the present embodiment, the region located on the cavity 4 of the piezoelectric films 3C and 3Dhas a free end on one end with a slit provided on three sides thereof, so that displacement of the free end is large, making it possible to obtain a larger displacement of the piezoelectric films 3a3 and 3a4, or making it possible to obtain a larger output signal associated with this displacement. Therefore, it is possible to further realize miniaturization and higher sensitivity. In other words, a small signal input can be received.

### [Piezoelectric module]

Next, an embodiment of a piezoelectric module of the present invention will be described. The piezoelectric module of the present invention comprises a plurality of piezoelectric devices of the present invention described above, and each of the piezoelectric devices has a piezoelectric film to be displaced at each different frequency by applying a voltage between a first electrode and a second electrode. In the above-described piezoelectric device of the present invention, the oscillation frequency (the resonance frequency) is determined by the thickness of the piezoelectric film, the dimensions between the electrodes, and the like. Thus, to increase the bandwidth of the oscillation frequency (the resonance frequency), piezoelectric devices with different frequencies of displacement of the piezoelectric films can be combined and modularized to achieve a wider bandwidth.

For example, as described above, in the piezoelectric device (100, 300) of Embodiment 1 or 3 of the present invention, by setting appropriately the thickness and the size of the piezoelectric film 3, and the interval between the pair of electrodes 5a and 5b, and setting appropriately the direction of application of the voltage to be applied between the pair of electrodes 5a and 5b, it is possible to transmit/receive an input/output signal by displacement (vibration) at a desired frequency. Moreover, in the piezoelectric device 200 of Embodiment 2 of the present invention, by also further setting appropriately the size and the arrangement of the individual piezoelectric units 6, it is possible to transmit/receive an input/output signal by displacement (vibration) at a desired frequency. Then, in the piezoelectric device 400 of Embodiment 4 of the present invention, by setting appropriately the thickness and the size of the individual piezoelectric films (3A, 3B) and the interelectrode interval for the individual pairs of electrodes (5a and 5b, 5c and 5d) and setting appropriately the direction of application of the voltage to be applied between the individual pairs of electrodes, it is possible to transmit/receive an input/output signal by displacement (vibration) at a desired frequency. It should be noted that the piezoelectric device 500 of Embodiment 5 of the present invention is to be similar to the piezoelectric device of Embodiment 1 in a case that the piezoelectric film is a single layer and is to be similar to the piezoelectric device of Embodiment 4 in a case that the piezoelectric film is a multilayer.

For the piezoelectric devices obtained by the above manner to be displaced (to vibrate) at respectively desired frequencies, by combining a plurality of piezoelectric devices to be displaced (to vibrate) at different frequencies, it is possible to obtain a piezoelectric module that can transmit/receive wide-band input/output signals.

The piezoelectric devices to be combined to configure the piezoelectric module are not particularly limited as long as they are displaced (vibrate) at different frequencies, so that the piezoelectric devices in different embodiments can be combined, or the piezoelectric device according to one embodiment can be combined in a plurality.

The embodiments of the piezoelectric device and the piezoelectric module of the present invention have been explained above, but it is needless to say that the invention is not limited to the above-described embodiments. For example, it is not limited to an ultrasonic transmission or reception apparatus.

### (Conclusion)

(1) A piezoelectric device of the present invention, in one embodiment, comprises: a substrate having a cavity; a piezoelectric film covering the cavity and laminated and supported on the substrate; and a first electrode and a second electrode being provided to be spaced apart from each other so as to sandwich a part of the piezoelectric film, wherein the first electrode and the second electrode pass through the piezoelectric film in the thickness direction of the piezoelectric film and are disposed above the cavity, and wherein an input signal is converted to an output signal based on displacement in a direction of application of a voltage to the piezoelectric film polarized in the direction of application of the voltage by applying the voltage between the first electrode and the second electrode.
   As the piezoelectric device of the embodiment in (1) above utilizes the longitudinal effect of the piezoelectric effect, displacement of the piezoelectric film is larger than that in a case of utilizing the transverse effect, or a larger output signal in relation to displacement can be obtained, making it possible to realize miniaturization and higher sensitivity of the piezoelectric device.
(2) According to another embodiment, in the piezoelectric device in (1) above, the first electrode and the second electrode are disposed concentrically, and an input signal is converted to an output signal based on the displacement of a donut-shaped part of the piezoelectric film between the first electrode and the second electrode.
(3) According to yet another embodiment, the piezoelectric device in (1) above comprises a plurality of piezoelectric units above the cavity wherein each of the piezoelectric units includes the first electrode, the second electrode and a part of the piezoelectric film between the first electrode and the second electrode, and an input signal is converted to an output signal based on the displacement of the piezoelectric film in the plurality of piezoelectric units and displacement of the piezoelectric film at a part between the plurality of piezoelectric units.
(4) According to yet a further embodiment, in the piezoelectric device in (2) above, an input signal is converted to an output signal based on the displacement of the donut-shaped part of the piezoelectric film and displacement of a circular part, which is surrounded by a piezoelectric unit including the first electrode and the second electrode and the donut-shaped part of the piezoelectric film, of the piezoelectric film.
(5) According to yet a further embodiment, in the piezoelectric device in any one of (1) to (4) above, at least two layers of the piezoelectric films are laminated so as to sandwich an insulating film, wherein each of the piezoelectric films has the first electrode, the second electrode, and a part of the piezoelectric film between the first electrode and the second electrode, and wherein an input signal is converted to an output signal based on displacement of at least either one of the displacement of an upper layer of the piezoelectric films with respect to the insulating film and the displacement of a lower layer of the piezoelectric films with respect to the insulating film.
(6) A piezoelectric module of the present invention, in one embodiment, comprises a plurality of piezoelectric devices each of which is the piezoelectric device according to any one of (1) to (4) above, and each of the piezoelectric devices has the piezoelectric film to be displaced at each different frequency by applying a voltage between the first electrode and the second electrode.
(7) According to another embodiment of the piezoelectric module of the present invention, the piezoelectric module comprises a plurality of piezoelectric devices each of which is the piezoelectric device according to (5) above, and each of the piezoelectric devices has the piezoelectric film to be displaced at each different frequency by applying a voltage between the first electrode and the second electrode.

### REFERENCE SIGNS LIST

100 to 500 PIEZOELECTRIC DEVICE
1 SUBSTRATE
2, 2a to 2d INSULATING FILM
3, 3a, 3b, 3a1 to 3a4, 3A to 3D PIEZOELECTRIC FILM
4 CAVITY
5a to 5h ELECTRODE
6 PIEZOELECTRIC UNIT
7 SLIT

## Claims

1. A piezoelectric device comprising:
a substrate having a cavity;
a piezoelectric film covering the cavity and laminated and supported on the substrate; and
a first electrode and a second electrode being provided to be spaced apart from each other so as to sandwich a part of the piezoelectric film,
wherein the first electrode and the second electrode pass through the piezoelectric film in the thickness direction of the piezoelectric film and are disposed above the cavity, and
wherein an input signal is converted to an output signal based on displacement in a direction of application of a voltage to the piezoelectric film polarized in the direction of application of the voltage by applying the voltage between the first electrode and the second electrode.

2. The piezoelectric device according to claim 1,
wherein the first electrode and the second electrode are disposed concentrically, and
wherein an input signal is converted to an output signal based on the displacement of a donut-shaped part of the piezoelectric film between the first electrode and the second electrode.

3. The piezoelectric device according to claim 1,
wherein the piezoelectric device comprises a plurality of piezoelectric units above the cavity wherein each of the piezoelectric units includes the first electrode, the second electrode and a part of the piezoelectric film between the first electrode and the second electrode, and
wherein an input signal is converted to an output signal based on the displacement of the piezoelectric film in the plurality of piezoelectric units and displacement of the piezoelectric film at a part between the plurality of piezoelectric units.

4. The piezoelectric device according to claim 2,
wherein an input signal is converted to an output signal based on the displacement of the donut-shaped part of the piezoelectric film and displacement of a circular part, which is surrounded by a piezoelectric unit including the first electrode and the second electrode and the donut-shaped part of the piezoelectric film, of the piezoelectric film.

5. The piezoelectric device according to any one of claims 1 to 4,
wherein at least two layers of the piezoelectric films are laminated so as to sandwich an insulating film, wherein each of the piezoelectric films has the first electrode, the second electrode, and a part of the piezoelectric film between the first electrode and the second electrode, and
wherein an input signal is converted to an output signal based on displacement of at least either one of the displacement of an upper layer of the piezoelectric films with respect to the insulating film and the displacement of a lower layer of the piezoelectric films with respect to the insulating film.

6. A piezoelectric module comprising a plurality of piezoelectric devices each of which is the piezoelectric device according to any one of claims 1 to 4,
wherein each of the piezoelectric devices has the piezoelectric film to be displaced at each different frequency by applying a voltage between the first electrode and the second electrode.

7. A piezoelectric module comprising a plurality of piezoelectric devices each of which is the piezoelectric device according to claim 5,
wherein each of the piezoelectric devices has the piezoelectric film to be displaced at each different frequency by applying a voltage between the first electrode and the second electrode.
